# EUROPEAN PATENT APPLICATION

(11) **EP 0 543 268 A2**
(43) Date of publication of application: **26.05.1993**
(21) Application number: 92119281.1
(22) Date of filing: 11.11.1992
(51) Int. Cl.: H01L 29/784, H01L 29/62, H01L 21/28

(54) **Transistor device with a gate structure and method of forming the same**

(30) Priority: 19.11.1991 US 795418
(71) Applicant: TEXAS INSTRUMENTS INCORPORATED, Dallas Texas 75265 (US)
(72) Inventor: Chapman, Richard A., Dallas, Texas 75240 (US)
(74) Representative: Schwepfinger, Karl-Heinz, Dipl.-Ing.

(57) **Abstract**

A method of forming a shallow doped region 125 in a semiconductor layer 112 is disclosed herein. An insulating layer 126 (e.g., silicon dioxide) is formed over the semiconductor layer 112. Next a thin (e.g., <20 nm), amorphous semiconductor layer 127 is formed over the insulating layer 126. Ions may then be implanted through the thin, amorphous semiconductor layer 127 and the insulating layer 126 and into the semiconductor layer 112 to form a shallow doped region 125. The shallow doped region 125 may have a peak concentration between 20 and 50 nm into the surface of the semiconductor layer. In a preferred embodiment, the shallow doped region 125 is formed in a buried channel transistor 119 such as for CMOS applications. Other systems and methods are also disclosed.

## Description

### FIELD OF THE INVENTION

This invention generally relates to the fabrication of semiconductor devices and specifically to a transistor device ad method of forming the same.

### BACKGROUND OF THE INVENTION

Very large scale integrated semiconductor circuits such as DRAMs are typically fabricated with metal oxide semiconductor field effect transistors (MOSFETs). The electrical characteristics of MOSFETs of a given size can be adjusted by techniques such as use of lightly doped drains, threshold adjustment implants, polysilicon gates, and so forth. As the number of MOSFETs per chip is increased, the MOSFET feature size is downscaled, and this leads to thinner gate oxides, shallower junctions, increased doping levels, lower operating voltages, and other features and also makes the achievement of good electrical characteristics more difficult.

The threshold adjustment implant has been common-place since the advent of ion implantation, and the first technique widely used was implanting p or n type dopants through the gate oxide prior to deposition of the gate. This technique has the problem of exposing the gate oxide to several processing steps, and the gate oxide integrity is compromised. This problem is exacerbated by downscaling due to the decreasing thickness of the gate oxide.

An alternative threshold adjustment implant technique is to implant through a dummy gate oxide which is later stripped and the true gate oxide grown followed immediately by the gate deposition. This technique yields good gate oxide integrity, but the growth of the gate oxide subsequent to the threshold implant implies high temperature processing steps and a diffusion of the threshold implant dopants. Further, implanted boron segregates into the oxide during growth; so the net effect is to have an undesirable deep implant. This leads to an increased body effect in n channel transistors and an increased short channel threshold rolloff due to a deeper buried channel.

A variation of the alternative threshold adjustment implant technique is to grow the gate oxide at low temperature to limit the implant dopant fusion. However, low temperature gate oxide growth leads to generally degraded quality of both the gate oxide and the interface of the gate oxide with the silicon. In particular both the oxide fixed charge and the interfacial trapped charge increase with decreasing processing temperature.

Thus it is a problem in the known threshold adjustment implant methods and threshold adjusted devices to have both good quality gate oxide plus a tight, shallow dopant profile.

### SUMMARY OF THE INVENTION

A method for providing threshold adjustment is disclosed in U.S. Patent No. 4,845,047 ('047), incorporated herein by reference. In this patent, the threshold of an FET is adjusted by implantation through a first split of a polysilicon gate plus gate oxide followed by completion of the gate. This permits a tight, shallow dopant profile plus high quality gate oxide and oxide/silicon interface and solves the problems of diffused and segregated implanted dopants in the known threshold adjustment methods and devices.

A problem exists, however, with the split polysilicon gate process of the '047 patent. When the first polysilicon gate layer is very thin, as is necessary for downsized structures, etchants and other undesirable chemicals can penetrate through the polysilicon layer at the grain boundaries. This creates problems in degrading the gate oxide layer beneath.

Other objects and advantages will be obvious, and will in part appear hereinafter and will be accomplished by the present invention which provides a method and apparatus for a transistor device and method of forming the same.

A method of forming a shallow doped region in a semiconductor layer is disclosed herein. An insulating layer (e.g., silicon dioxide) is formed over the semiconductor layer. Next a thin (e.g., <20 nm), amorphous semiconductor layer is formed over the insulating layer. Ions may then be implanted through the thin, amorphous semiconductor layer and the insulating layer and into the semiconductor layer to form a shallow doped region. The shallow doped region may have a peak concentration between 20 and 50 nm into the surface of the semiconductor layer.

In one embodiment, a transistor device is formed in a semiconductor layer. The device includes a source and drain region of a first conductivity type separated by a channel region comprising a second conductivity type. The channel region also includes a shallow doped region of the first conductivity type. An insulating layer (e.g., silicon dioxide) overlies the channel region. A thin, semiconductor layer which may be recrystallized insulatively overlies the channel region and a polycrystalline semiconductor layer overlies the thin semiconductor layer.

The transistor design usually referred to as a "buried channel" transistor requires a very shallow compensating implant immediately under the gate oxide of an MOS transistor. The buried channel design is used in PMOS (p-channel metal oxide semiconductor) transistors for gate lengths of 0.5 µm or longer. This discussion will refer to buried channel PMOS transistor as the best example. However, buried channel NMOS (n-channel MOS) transistors may also be formed.

To prevent the subsequent growth of gate oxide from consuming part of the compensating implant and from driving the remainder of the compensating implant deeper into the silicon by thermal diffusion, it is necessary to implant the compensating implant after the growth of the gate oxide. Unfortunately, for optimum CMOS designs with gate lengths less than 0.5 µm, it is necessary to restrict the implant to the PMOS transistors by a photoresist pattern. Resist patterning directly on top of gate oxide is a risky procedure for very thin gate oxide such as the 6 nm to 10 nm gate oxide thicknesses needed for 0.35 µm CMOS technology. The deposition of a very thin amorphous silicon layer on top of the gate oxide will protect the gate oxide from all of the chemicals used in the photoresist process and from the oxide deglaze process necessary to clean the thin amorphous silicon layer before deposition of the thicker polysilicon layer needed to form the gates of the CMOS transistors. If the thin silicon layer is amorphous and free of grain boundaries as in this invention, then the layer can be made thin enough to prevent broadening of the compensating implant distribution thereby creating the very shallow implant distribution needed for very short channel buried channel transistors.

### BRIEF DESCRIPTION OF THE DRAWINGS

The above features of the present invention will be more clearly understood from consideration of the following descriptions in connection with accompanying drawings in which:
Figure 1 is a conventional CMOS device using surface channel NMOS and PMOS transistors;
Figure 2 is a CMOS device built according to the present invention;
Figures 3 and 4 illustrate a CMOS device during selected steps of the process flow;
Figure 5 illustrates the doping profile for various methods of forming a buried channel device; and
Figures 6-10 graphically illustrate the performance of exemplary transistor devices.

Corresponding numerals and symbols in the different figures refer to corresponding parts unless otherwise indicated.

### DETAILED DESCRIPTION OF PREFERRED EMBODIMENTS

The making and use of the presently preferred embodiments are discussed below in detail. However, it should be appreciated that the present invention provides many applicable inventive concepts which can be embodied in a wide variety of specific contexts. The specific embodiments discussed are merely illustrative of specific ways to make and use the invention, and do not delimit the scope of the invention.

A description of the prior art CMOS devices will first be presented along with a brief summary of some of the fabrication problems. Next, an exemplary device built according to the present invention will be presented followed by a preferred method of fabrication. Some graphical data will then be presented to illustrate the operation of an exemplary device. A brief discussion of modifications will finally be given.

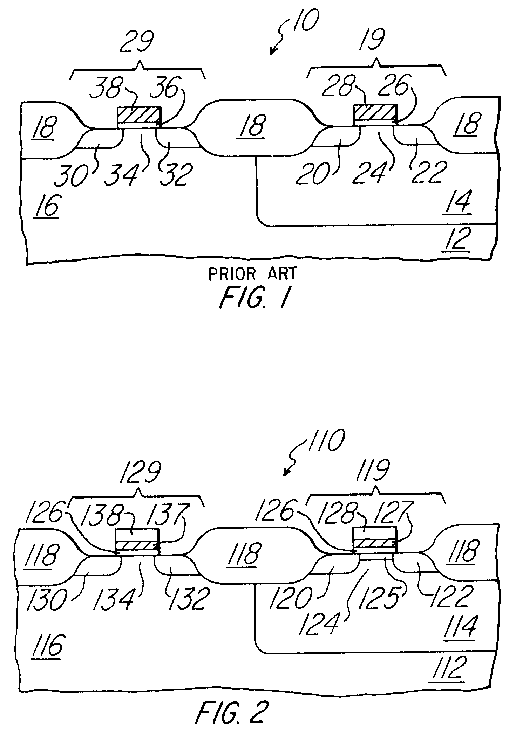

Referring first to Fig. 1, a conventional CMOS device 10 is shown. A semiconductor substrate 12 includes an n-well region 14 and a p-well region 16.

A PMOS transistor 19 includes source 20, drain 22 and channel 24 and is formed in the n-well region 14. A gate oxide layer 26 overlies the channel 24 and insulates a gate 28 from the channel 24.

Similarly, an NMOS transistor includes source 30, drain 32 and channel 34 and is formed in the p-well region 16. A gate oxide layer 36 overlies the channel 34 and insulates a gate 38 from the channel 34. A field oxide region 18 separates the transistors from each other.

Most CMOS processes use n-type doped polysilicon for both NMOS gate 38 and PMOS gate 28. However, this design makes it difficult to build good PMOS transistors when the dimensions are far into the submicron range.

For CMOS designs with gates 0.5 µm long or less, the easiest design to implement is to use polysilicon gates that are doped only by the patterned source/drain implants with the result that the NMOS transistors 29 have n+ polysilicon gates 38 and the PMOS transistors 19 have p+ polysilicon gates 28. Thus, the NMOS transistors 29 have n+ gates 38 over a p-type doped channel region 34 while the PMOS transistors 19 have p+ gates 28 over a n-type doped channel region 24. In this design, both NMOS and PMOS transistors are "surface channel", i.e., the entire channel region 24 (34) is of opposite conductivity as the source 20 (30) and drain 22 (32). Because the gate 38 (38) and the channel 24 (34) are of different conductivity types, the threshold voltages for each type are decreased by about the value of the silicon bandgap. For instance, if the natural threshold voltages for NMOS and PMOS are both 1.8V, then the surface channel threshold voltages will be about 0.8V for both NMOS and PMOS. This permits using high concentration doping in the MOS channels to prevent punchthrough while still preserving the low threshold voltages required for high drive currents and fast circuit response.

In other situations, both gates 28 and 38 are doped to the same conductivity type. For example, in the oldest CMOS processes using all n+ poly gates 28 and 38, the NMOS transistors 29 are still surface channel but there are design problems for the PMOS transistors 19. Since the n+ poly gate 28 uses the same dopant conductivity type as the channel region 24 of the PMOS transistors 19, the threshold voltage is not reduced. For instance, the PMOS threshold voltage may be 1.8V for a channel doping sufficient to prevent punchthrough from source 20 to drain 22 when the supply voltage is applied to the drain. To lower the PMOS threshold voltage, a very shallow profile compensating dopant must be added immediately underneath the gate oxide 26. This dopes the surface of the channel region to the opposite type of the gate and, as in the case with the surface channel design, reduces the threshold voltage to an acceptable value. Although this compensating implant changes the surface doping of the PMOS channel 24 from n-type to p-type, the junction to the p-type bulk underneath the channel results in the thin p-type region being fully depleted. Although the design is usually referred to as "buried channel," there is no "buried channel" because of this depletion.

In the conventional CMOS designs, typically using 0.8 µm gate lengths and longer, the compensating p-type (e.g., boron) implant needed for the PMOS transistors is implanted through the pregate ("dummy gate") oxide (not shown) that is grown and stripped before the gate oxide is grown. The boron implant does not have to be patterned and can be implanted into both NMOS channel 34 and PMOS channels 24. In this case, the NMOS threshold voltage is increased at the same time that the PMOS threshold is decreased. The usual procedure is to lower the p-well doping for the NMOS transistor so that the unpatterned p-type channel implant does not result in too large a value of threshold voltage for the NMOS transistor.

However, for CMOS technologies using less than 0.8 µm gate lengths, the use of an unpatterned p-type channel implant is not practical because this compensating dopant profile must be so shallow in depth for the PMOS that this profile is too shallow to prevent punchthrough in the NMOS transistor. It would be necessary to add a patterned boron p-type higher energy implant for the NMOS transistor.

Unfortunately, if patterned channel implants are used for the NMOS and PMOS transistors in the CMOS design, this creates some severe process problems for transistors with dimensions in the deep submicron regime. All deep submicron designs require very shallow profiles for the compensating dopant in the buried channel design. If these implants are made through the pregate dummy oxide, the later growth of the gate oxide will result in: (1) loss of the compensating dopant to the gate oxide (and loss to the ambient by diffusion through the growing gate oxide) and (2) diffusion of the compensating dopant deeper into the silicon resulting in a deeper profile.

Since the compensating dopant cannot be implanted through the pregate oxide, it must be implanted through the gate oxide 26. However, the need to use patterned channel implants for deep submicron CMOS designs causes severe problems with this approach. For instance, photoresist (not shown) must be placed on top of a very thin gate oxide 26 (6nm to 10nm thick), a deep UV exposure made, a wet developer used to remove the patterned parts of the resist, a UV bake used to harden the resist, the implant made, the resist removed by a plasma ash, and finally a wet cleanup used to remove resist residue. Unfortunately, many of the above procedures may damage the gate oxide 26 or add contaminants. The reduced quality of the gate oxide 26 may not be immediately detected but will probably cause the NMOS transistors 29 to later degrade rapidly in operation due to charge trapping at defects in the oxide 26 caused by hot carrier generation in the NMOS transistors.

One approach used for CMOS with buried channel PMOS at the 0.8 µm design node is to split the deposition of the polysilicon into two parts (see for example R. A. Chapman, et al., Proceeding of the 1987 IEDM, pg 362-365 (1987)). The first deposition of polysilicon is 125 nm thick; this is thin enough that a 60keV boron compensating implant could be made though the polysilicon and gate oxide. In the second deposition, enough polysilicon is added to make the total thickness 450 nm. A HF deglaze is typically necessary to remove native oxide from the surface of the first polysilicon layer before the second polysilicon layer is deposited. Previous studies have shown that gate oxide integrity will be degraded if the first polysilicon layer is less than 100 nm thick. The assumed reason for this loss of gate oxide integrity is that the etch to remove the native oxide will diffuse through the grain boundaries in the first polysilicon layer and attack the gate oxide underneath. Unfortunately, a first layer of polysilicon 100 nm thick or greater may cause too much scattering (straggle) of the implanted boron ions with the result that the boron distribution is spread out too much to provide a profile shallow enough for CMOS in the deep submicron regime.

At this point in the discussion, it would appear that only possible approach for deep submicron designs would be the n+/p+ poly design resulting in all surface channel transistors. This is the easiest approach and may need to be accepted at some point as transistors are scaled to smaller dimensions. However, many of the complex fabrication processes now used for CMOS products such as DRAMs and SRAMs depend on the use of all n+ poly gates. The present invention provides a fabrication process and resulting structure which solve many of these problems.

Referring now to Figure 2, a CMOS device 110 built according to the present invention is shown. Figure 2 is similar to Figure 1 but also includes a thin silicon layer 127 formed beneath gate 128 and a thin silicon layer 137 formed beneath gate 138. The thin silicon layer 127 (137) is deposited as an amorphus layer and may later be recrystallized (or partially recrystallized) into a polycrystalline state. For the purpose of this invention, the amorphous layer is defined to be a semiconductor in which grain boundaries which would allow chemical penetration are substantially eliminated or do not reach the top surface of the amorphous semiconductor layer.

In the preferred embodiment, the substrate 112 comprises silicon. The gate insulator 126 and the field insulating regions 118 are typically an oxide such as silicon dioxide. In the preferred embodiment, both gates 138 and 128 are doped with the same type impurities such as n-type impurities (e.g., arsenic or phosphorus).

Also illustrated in Figure 2, is a shallow, doped channel region 125. The shallow doped channel region 125 is doped with the same type impurities and the source 120 and drain 125 and is formed to adjust the threshold voltage of the transistor 119 as discussed above.

To eliminate the deleterious effects mentioned in the above discussion, the thin silicon layer 127 (137) is deposited on top of the gate oxide 126 before performing patterned implants (i.e. to form shallow doped region 125) through the gate oxide 126. In order to eliminate damage to the gate oxide 126, the deposited silicon must be free of grain boundaries. As is known, when non-crystalline silicon is deposited on top of oxide without grain boundaries in the silicon, this material is called amorphous silicon. As is known in the art, the structure of deposited silicon is strongly influenced by dopants, impurities, and deposition temperature. To obtain amorphous silicon, the substrate temperature must be reduced to 590 °C or below which is lower than used for the deposition of polycrystalline silicon. In the preferred embodiment, the amorphous silicon is deposited at about 560 °C. The temperature may be varied, however, as long as the grain boundaries which would allow chemical penetration are substantially eliminated or do not reach the top surface of the amorphous silicon layer.

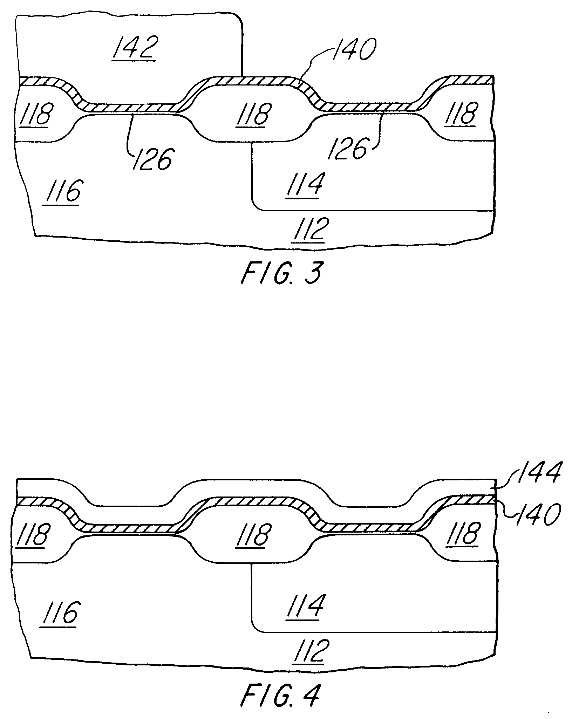

A preferred method of fabrication is illustrated in the cross-sections views shown in Figure 3 and 4. Referring first to Figure 3, a semiconductor (preferably silicon) workpiece is provided. Field insulating regions 118 have been formed using known techniques such as thermally growing an oxide, for example. In addition, the well regions 114 and 116 have been formed. In the preferred embodiment, well region 114 is doped with n-type impurities and region 116 is doped with p-type impurities. The substrate 112 may be doped with p-type impurities. Methods for forming well regions are well known in the art. Of course, in typical applications many wells may exist.

Gate insulators 126 are formed on the surface of the workpiece. In a preferred embodiment, an 8 nm oxide layer 126 is thermally grown using known techniques. For transistors designed with submicron length gates, the layer 126 may typically be between 4 and 12 nm thick.

Next a thin, amorphus semiconductor layer 140 is grown. In the preferred embodiment, the semiconductor is silicon. This layer 140 is typically thinner than 20 nm or 15 nm and may be as thin as 10 nm or 7.5 nm or less. It is important that the amorphus layer 140 be thin so that a low implant energy can be used and the implant straggle can be reduced to a minimum value. It is also important that the layer 140 have a limited number of grain boundaries so that the chemicals used in subsequent process steps cannot penetrate it and disturb the oxide layer 126 beneath.

The next step is to pattern a photoresist layer 142 so that p-type ions (e.g. boron) can be implanted into the regions where the PMOS transistors are to be built and blocked from the regions where NMOS transistors are to be built.

One of the advantages of the present invention is that the chemicals used to form resist pattern 142 cannot penetrate the amorphous layer 140. In some prior art processes, the resist pattern 142 is formed directly on oxide layer 126 which may contaminate the oxide layer 126.

Next ions are implanted through the gate oxide 126 and the thin amorphous layer 140 to form the buried channel as previously described. Since the gate oxide is thin (e.g. 8 nm) and the amorphous layer is thin (e.g. 10 to 20 nm), the total layer that the implant must only go through is thin. This advantage will allow for a shallow junction in the channel region of the transistor.

Referring now to Figure 4, the photoresist 142 is thoroughly stripped away. Once again oxide 126 is protected by amorphous layer 140 during this strip process.

A thin native oxide layer (not shown) will form over the amorphous silicon layer 140. This native oxide must be removed to obtain good electrical contact between the amorphous silicon layer 140 and the polysilicon layer 144 to be deposited in a later step. Methods for removing native oxides are known. Once again, the amorphous silicon layer 140 will protect the underlying gate oxide 126 from the chemicals used to eliminate the native oxide.

In practice, the removal of the native oxide may create problems. In one experiment, "amorphous" silicon 140 was deposited but actually had a low density occurrence of small diameter silicon crystallites near the interface with the gate oxide 126. For thick amorphous silicon layers, this is not serious since the amorphous layer covers the crystallites. For very thin layers, such as 20 nm or less, the crystallites continue to the outer (upper) surface of the amorphous layer and thereby give grain boundaries that extend completely through the layer. Accordingly, it may be necessary to modily the deposition temperature and flow rates to produce an amorphous layer that is impervious to the wet deglaze of the native oxide. In the preferred embodiment, the deposition temperature is between about 520 and 590 °C and silane plus argon was flowed into the process chamber at a rate of between about 100 and 1000 sccm (standard cubic centimeters per minute) for silane and about 1 to 10 slm (standard liters per minute) for argon.

After removing any native oxide, a relatively thick polysilicon layer 144 is added on top of the amorphous layer 140. The thickness of the polysilicon layer 144 is determined by the desired thickness of the transistor gates. The layer 144 may be deposited as polycrystalline or deposited as amorphous silicon and recrystallized. The amorphous layer 140 may also be recrystallized.

Next, the polysilicon/amorphus silicon layer 140 and 144 is doped and the gate 128 (138) patterned and etched using known processing techniques. Source 120 and 130 and drain 122 and 132 are then formed using known techniques. The resulting structure is shown in Figure 2. In addition, as known sidewall spacers (not shown) or lightly doped drain (LDD) regions (not shown) may be included adjacent to the gates. Interconnections, passivation, and packaging have also been omitted for clarity.

Simulations were performed to optimize the process for building buried channel PMOS transistors by implanting the compensating boron implant through amorphous silicon. To obtain compensating junction depths of 0.07 µm or less, it is desirable that the amorphous silicon be no greater than 20 nm thick. If the gate oxide is 8 nm, this requires that the boron implant pass through a total thickness of 28 nm. The stopping power of silicon and silicon oxide are similar for boron implants. A total thickness of 28 nm is similar to the 25 nm pregate dummy oxide used in the standard buried channel fabrication process.

When 20 nm of amorphous silicon is used, the boron implant energy must typically be about 15 kev to assure that most of the boron reaches the silicon. The energy can be lowered to about 10 keV, but about 20% of the boron is left in the amorphous silicon and gate oxide. Thinner layers of amorphous silicon would be preferable and layers of 10 nm should be practical.

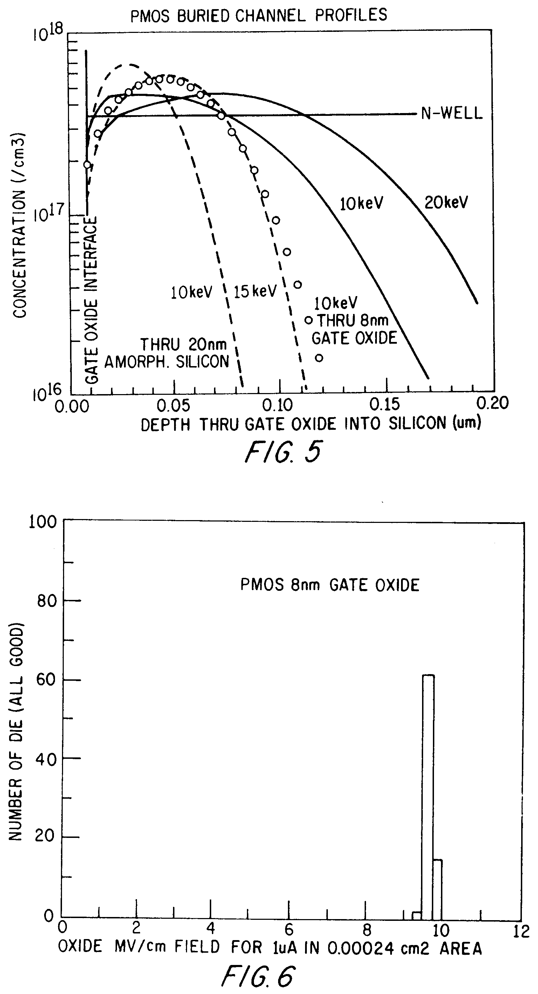

The graphs of Figures 5 through 10 illustrate the performance of an exemplary CMOS application of the present invention. Specifically, Figure 5 compares SUPREM3 simulation results for several methods of forming buried channel PMOS transistors. The gate oxide 126 to channel 125 interface is shown on the left hand side of the figure.

The deepest profiles are obtained when the boron implant is performed through the sacrificial (dummy) oxide grown before gate oxide (prior art method). The two solid curves on the right hand side of the slide show the cases for 20keV and 10keV boron implants.

The two dashed curves on the left hand show the more shallow profiles obtained when either a 10keV or a 15keV implant is performed through a 20nm amorphous silicon film as described in this patent. If the implant were to be performed through the gate oxide instead, the profile shown by the circled points would be obtained: however, this method risks contaminating or damaging the gate oxide.

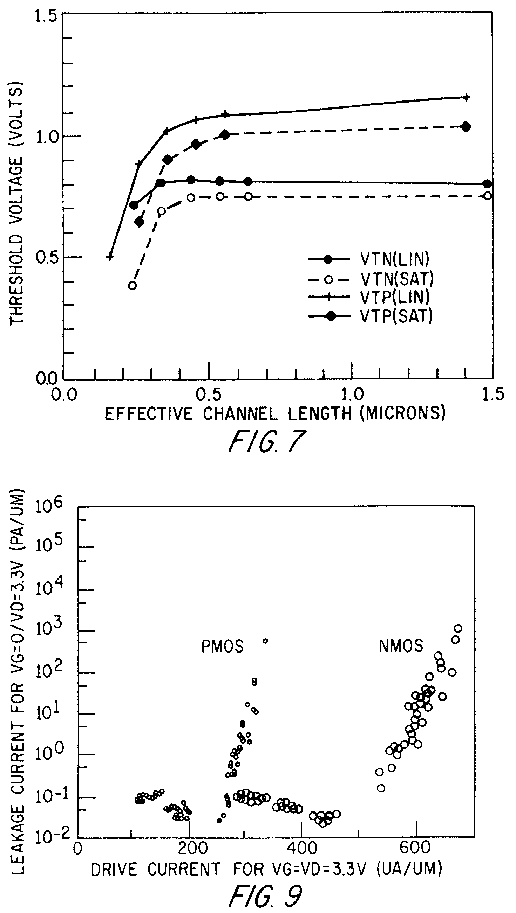

Figure 6 shows that a very tight distribution of gate oxide breakdown voltages was obtained using this process for a full-flow CMOS lot. This ramped voltage test gives a breakdown field of about 10 MV/cm. Destructive breakdown occurs near 12 MV/cm. Charge to breakdown measurements give 25 Coulombs/cm2 at 10mA/cm2 bias current.

Figure 7 shows the linear and 3.3V saturation threshold voltages for NMOS and PMOS from a full-flow CMOS lot. Both transistors have excellent characteristics in the range of 0.3µm effective channel length.

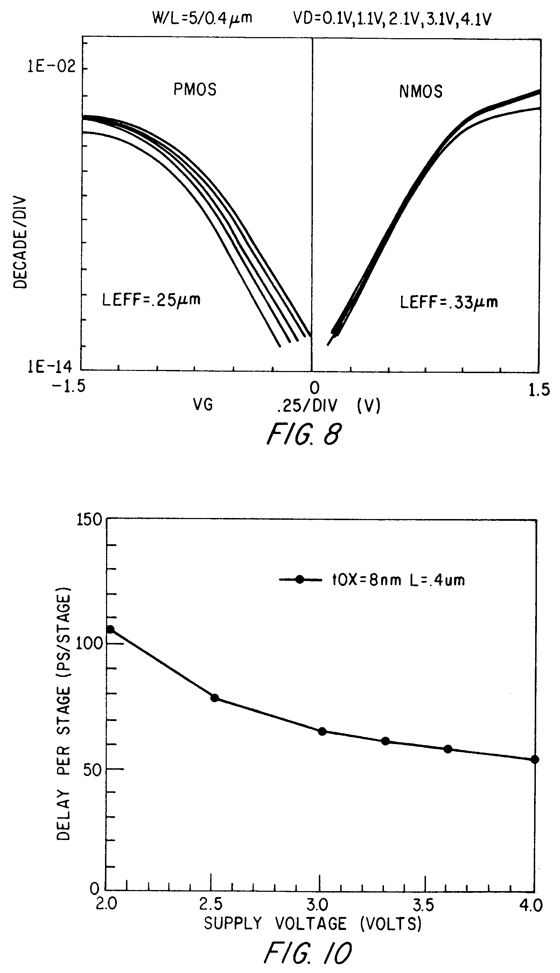

Figure 8 shows the subthreshold turn-off characteristics of the NMOS and PMOS transistors with design widths of 5µm and design lengths of 0.4µm. The subthreshold slopes are both in the range of 90-100mV/decade consistent with 8nm gate oxide and 4E17/cm3 doping. The 3.3V drive currents for these transistors are 420µA/µm for NMOS and 250µA/µm for PMOS. The effective channel lengths for these transistors are 0.33µm NMOS and 0.25µm for PMOS. NMOS transistors with 0.23µm effective channel length also have excellent characteristics but characteristics for these devices are not shown in this figure. The 0.23µm NMOS transistors have 90mV/decade subthreshold slope and 550µA/µm drive current.

Figure 9 compares the "off" current for zero gate voltage to the drive current for both NMOS and PMOS transistors. The "off" current increases when the saturation threshold voltage decreases to a value permitting larger subthreshold leakage for zero gate voltage. The determining factor is effective channel length for both the "off" current and the drive current. In addition, at 10pA/µm, the drive currents are approximately 300µA/µm PMOS and 600µA/µm for NMOS for a drain voltage of +3.3 V for NMOS and -3.3 V for PMOS.

Figure 10 shows the delay per stage of an unloaded inverter chain using W/L CMOS transistors of 10µm/0.4µm design. At 3.3V, the delay per stage is 65ps/stage for this chain using NMOS transistors with 0.33µm effective channel length and PMOS transistors with 0.25µm channel length. It is expected that shorter delay times could have been obtained using NMOS with 0.23µm effective channel length.

In general, the process disclosed herein can be used whenever it is necessary to protect the gate oxide from process steps that might damage it. For example, split poly deposition processes are used in the BiCMOS processes. Even more generally, the process may be used whenever a layer beneath a polysilicon layer must be protected.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A transistor device formed in a semiconductor layer comprising:
a source and drain region of a first conductivity type separated by a channel region comprising a second conductivity type, said channel region including a shallow doped region of said first conductivity type;
an insulating layer overlying said channel region;
a first semiconductor layer insulatively overlying said channel region; and a second semiconductor layer overlying said first layer.

2. The device of claim 1, wherein the first semiconductor layer is at least partially recrystallized.

3. The device of claim 1 or claim 2, wherein the second semiconductor layer is a polycrystalline layer.

4. The device of claims 1 to 3 wherein said semiconductor comprises silicon and said insulating layer comprises silicon dioxide.

5. The device of any preceding claim, wherein said first semiconductor layer compries a amorphous semiconductor layer.

6. The device of any preceding claim, wherein said second layer is doped with impurities of said second conductivity type.

7. The device of any preceding claim, wherein said first conductivity type is n-type.

8. The device of claim 7, wherein the n-type material comprises boron.

9. The device of any preceding claim, wherein said shallow doped region has a peak doping concentration between about 20 ad 50 nm from the interface between said insulating layer ad said semiconductor layer.

10. The device of any preceding claim, wherein said first semiconductor layer is about 200 or less angstroms thick

11. The device of claim 10, wherein first semiconductor layers is between about 75 and 100 angstroms thick.

12. A CMOS transistor device comprising:
a semiconductor workpiece including an n-well region ad a p-well region;
n-doped source and drain regions formed in said p-dwell region;
p-doped source and drain regions formed in said n-well region;
a p-doped NMOS channel separating said n-doped source and drain regions;
a n-doped PMOS channel separating said p-doped source and drain regions, said PMOS channel region including a shallow p-doped region;
an insulating layer formed over said channels;
a thin, at least partially recrystallized semiconductor layer semiconductor layer formed over said insulating layer; and
a polycrystalline semiconductor overlying said thin, at least partially recrystallized semiconductor layer semiconductor layer.

13. The device of claim 12, further comprising a field oxide region formed between said n-well region and said p-well region.
